# EUROPÄISCHE PATENTSCHRIFT

(11) **EP 1 019 958 B1**
(45) Veröffentlichungstag und Bekanntmachung des Hinweises auf die Patenterteilung: **23.04.2003**
(21) Anmeldenummer: 98958161.6
(22) Anmeldetag: 22.09.1998
(51) Int. Cl.: H01L 21/762

(54) **VERFAHREN ZUR AUSBILDUNG EINER GRABENSTRUKTUR IN EINEM SILIZIUMSUBSTRAT**
METHOD FOR MAKING A GROOVE STRUCTURE IN A SILICON SUBSTRATE
PROCEDE DE FORMATION D'UNE STRUCTURE DE FOSSE DANS UN SUBSTRAT EN SILICIUM

(30) Priorität: 24.09.1997 DE 19742174
(43) Veröffentlichungstag der Anmeldung: 19.07.2000
(73) Patentinhaber: Infineon Technologies AG, 81669 München (DE)
(72) Erfinder: BRADL, Stephan, D-01157 Dresden (DE); HEITZSCH, Olaf, D-01640 Coswig (DE); SCHMIDT, Michael, D-01458 Ottendorf-Okrilla (DE)
(74) Vertreter: Lange, Thomas, Dr.
(86) Internationale Anmeldenummer: DE9802832
(87) Internationale Veröffentlichungsnummer: WO99016125

(56) Entgegenhaltungen:
- EP-A- 0 341 898
- US-A- 4 226 665
- US-A- 4 671 970
- US-A- 5 294 294

## Beschreibung

Die Erfindung betrifft ein Verfahren zur Ausbildung einer Grabenstruktur in einem Siliziumsubstrat nach den Merkmalen des Oberbegriffs des Anspruchs 1.

Durch die steigende Integrationsdichte bei Halbleiterbauelementen werden die Anforderungen an die elektrische Isolation von benachbarten aktiven Gebieten auf einem Halbleitersubstrat ständig höher. Bei der gegenwärtig zur Herstellung von integrierten Schaltungen in großem Umfang eingesetzten LOCOS-Technik (Local Oxidation of Silicon) wird die elektrische Isolation benachbarter MOS-Transistoren durch die lokalisierte Ausbildung eines Feldoxids erreicht. Bei diesem Verfahren kommt es im Übergangsbereich zwischen dem Feldoxid und dem Gateoxid zu der Ausbildung eines sogenannten Vogelschnabels (bird beak). Nachteilig an diesem Vogelschnabel ist, daß er aufgrund seiner lateralen Ausdehnung die für aktive Bereiche zur Verfügung stehende Halbleitersubstratfläche reduziert und somit bei Strukturen im Bereich von 0,35 µm oder darunter zu signifikanten Schwierigkeiten führt.

Als Alternative zur LOCOS-Technik ist die Grabenisolationstechnik (STI: Shallow Trench Isolation) vorgeschlagen worden. Bei der Grabenisolationstechnik werden schmale Gräben in das monokristalline Siliziumsubstrat geätzt und anschließend mit einem isolierenden Material ausgefüllt. Die gefüllten Gräben wirken dann als platzsparende elektrische Isolationsbarrieren zwischen aktiven Bereichen. Diese Technik ist sowohl für die elektrische Isolation eng benachbarter Bipolartransistoren als auch von p- und n-Kanal-MOS-Transistoren in CMOS-Schaltungen in hohem Maße geeignet. Nachteilig ist jedoch, daß der Einsatz dieser Technik einen hohen Prozeßaufwand erforderlich macht und daher mit hohen Kosten verbunden ist.

Eine Verbesserung der Grabenisolationstechnik wird in EP-A-0 341 898 offenbar.

Der hohe Prozeßaufwand ist im wesentlichen darauf zurückzuführen, daß nach dem Auffüllen des Grabens mit Siliziumdioxid der Grabenverlauf in die Siliziumdioxidschicht transferiert ist und daher eine weitere, einebnende Schicht, beispielsweise ein Photoresist oder eine Polysiliziumschicht, auf die Siliziumdioxidschicht aufgebracht werden muß, wodurch sich beim nachfolgenden planaren Abtragen der Schicht Ebenheitsprobleme aufgrund der unterschiedlichen Schichtmaterialien ergeben. Diese müssen dann durch zusätzliche Prozesse ausgeglichen werden, um nach Entfernung der Siliziumdioxidschicht wiederum eine planare Substratoberfläche zu erhalten.

Der vorliegenden Erfindung liegt die Aufgabe zugrunde, ein Verfahren anzugeben, mit dem eine Grabenstruktur in einem Siliziumsubstrat auf möglichst einfachem und kostengünstigem Wege hergestellt werden kann.

Zur Lösung dieser Aufgabe sind die Merkmale des Anspruchs 1 vorgesehen.

Durch die Nichtselektivität des im Merkmal g) definierten Ätzschrittes wird erreicht, daß die in dem vorhergehenden chemisch-mechanischen Polierschritt (CMP: Chemical-Mechanical-Polishing) gemäß Merkmal f) geschaffene Ebenheit beim gemeinsamen Ätzen des Polysiliziummaterials und Oxidmaterials aufrechterhalten wird, bis sämtliches Polysiliziummaterial entfernt ist. Dadurch wird die gemeinsame Abtragung des Polysilizium- und Oxidmaterials durch einen einzigen, kostengünstigen Ätzschritt ermöglicht. Ein weiterer Polierschritt wird in der Regel nicht mehr benötigt. Ferner gestattet diese Vorgehensweise auch die Einstellung einer definierten Oxid-Restschichtdicke über dem Silizium, sofern die Dicke der zuvor abgeschiedenen Deckoxidschicht um mehr als die gewünschte Restschichtdicke größer als die Tiefe des Grabens war.

Vorzugsweise handelt es sich bei dem nichtselektiven Ätzschritt um einen Plasmaätzschritt, wobei als Ätzgase vorzugsweise NF₃/N₂/CHF₃-Gase verwendet werden.

In vorteilhafter Weise kann nach dem nichtselektiven Ätzschritt ein selektiver Ätzschritt zur Entfernung von Oxidmaterial durchgeführt werden. Dies gestattet es, durch Ätzung des im Graben deponierten Oxids einen vorgegebenen Abstand zwischen der Oberfläche des Siliziumsubstrats und der Oberfläche des Grabenoxids einzustellen. Außerdem kann dieser selektive Ätzschritt zur Entfernung von Oxidmaterial außerhalb des Grabens verwendet werden.

Grundsätzlich ist es bei dem erfindungsgemäßen Verfahren nicht erforderlich, eine Siliziumnitridschicht auf die thermische Oxidschicht aufzubringen, da die im Stand der Technik bei einem CMP-Schritt ausgenutzte Stoppwirkung der Siliziumnitridschicht hier nicht benötigt wird. Es kann jedoch aus anderen Gründen weiterhin zweckmäßig sein, eine Siliziumnitridschicht vorzusehen, beispielsweise um diese als Maskenschicht für die Grabenätzung einzusetzen.

Weitere bevorzugte Ausführungsvarianten der Erfindung sind in den Unteransprüchen angegeben.

Die Erfindung wird nachfolgend in beispielhafter Weise anhand der Zeichnung beschrieben; in dieser zeigt:
Fig. 1 eine Darstellung der Abfolge von Prozeßschritten eines speziellen Verfahrens nach dem Stand der Technik,
Fig. 2 eine Darstellung der Abfolge von Prozeßschritten, die bei einem ersten Ausführungsbeispiel des erfindungsgemäßen Verfahrens auftreten,
Fig. 3 eine Darstellung der Abfolge von Prozeßschritten, die bei einem zweiten Ausführungsbeispiel des erfindungsgemäßen Verfahrens auftreten, und
Fig. 4 eine rasterelektronenmikroskopische Aufnahme eines erfindungsgemäß gebildeten Grabenprofils nach einer selektiven Oxid-Naßätzung.

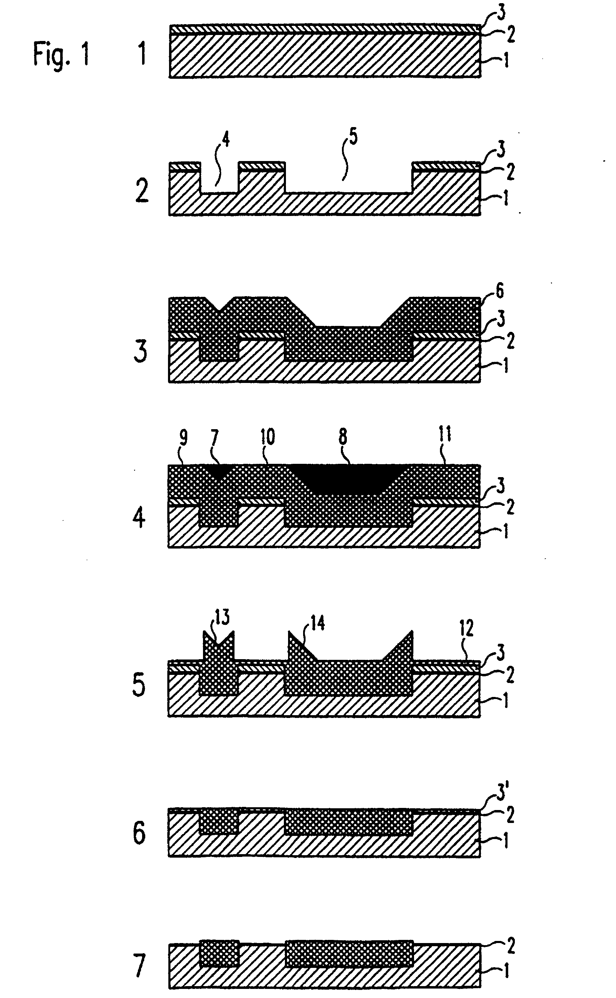

Fig. 1 zeigt Prozeßschritte eines bekannten Verfahrens zur Erzeugung einer Grabenstruktur. Zunächst wird auf einem Siliziumsubstrat 1 eine dünne thermische Oxidschicht (SiO₂-Schicht) 2 und eine darüberliegende, dickere Nitridschicht (Si₃N₄) 3 aufgewachsen (Schritt 1). Nach einer Strukturierung der Oxid- und Nitridschichten 2, 3 werden durch einen Ätzprozeß Gräben 4, 5 definierter Tiefe in das Siliziumsubstrat 1 eingebracht (Schritt 2). Danach wird auf das gesamte Substrat 1 eine in Fig. 1 nicht dargestellte Zwischenoxidschicht aufgewachsen, die als Unterlage für eine anschließend mittels Gasphasenabscheidung aufgebrachte undotierte TEOS-Oxidschicht 6 (TEOS: Tetra-Ethyl-Ortho-Silicate) dient (Schritt 3). Schritt 4 umfaßt die Abscheidung von undotiertem Polysilizium auf der TEOS-Oxidschicht 6 und einen nachfolgenden chemisch-mechanischen Poliervorgang (Poly-CMP) zur Erzielung einer planaren Schichtoberfläche. Von der Polysiliziumschicht bleiben die in Fig. 1 dargestellten Polysiliziuminseln 7, 8 zurück. Diese Inseln 7, 8 werden in einem folgenden Plasmaätzschritt als Masken verwendet, um die nichtmaskierten TEOS-Schichtbereiche 9, 10, 11 der TEOS-Oxidschicht 6 selektiv bis auf eine Restoxidschicht 12 über der Nitridschicht 3 abzuätzen. Dann werden durch einen weiteren selektiven Plasmaätzschritt die Polysiliziuminseln 7, 8 aus den übriggebliebenen Strukturen 13, 14 der TEOS-Oxidschicht 6 entfernt (Schritt 5). Im weiteren folgt eine Planarisierung der übrig gebliebenen Oxidstrukturen 13, 14 durch einen chemisch-mechanischen Poliervorgang (Oxid-CMP), bei der die Nitridschicht 3 als Stoppschicht verwendet wird. Bei diesem Schritt muß ein Teil der Nitridschicht 3 abgetragen werden, um sicherzustellen, daß jegliches Oxid vollständig von der Nitridschicht 3 entfernt wurde, wobei die Nitridschicht 3 aufgrund ihrer relativ schwachen Stoppwirkung im Oxid-CMP-Prozeß (Selektivität ∼ 1:4) eine verhältnismäßig große Dicke (etwa 150 nm) aufweisen muß (Schritt 6). In einem letzten Schritt wird dann die Restnitridschicht 3' selektiv durch einen weiteren Ätzschritt vollständig entfernt, so daß die dünne Oxidschicht 2 an der Oberfläche des Substrats 1 freiliegt. (Schritt 7).

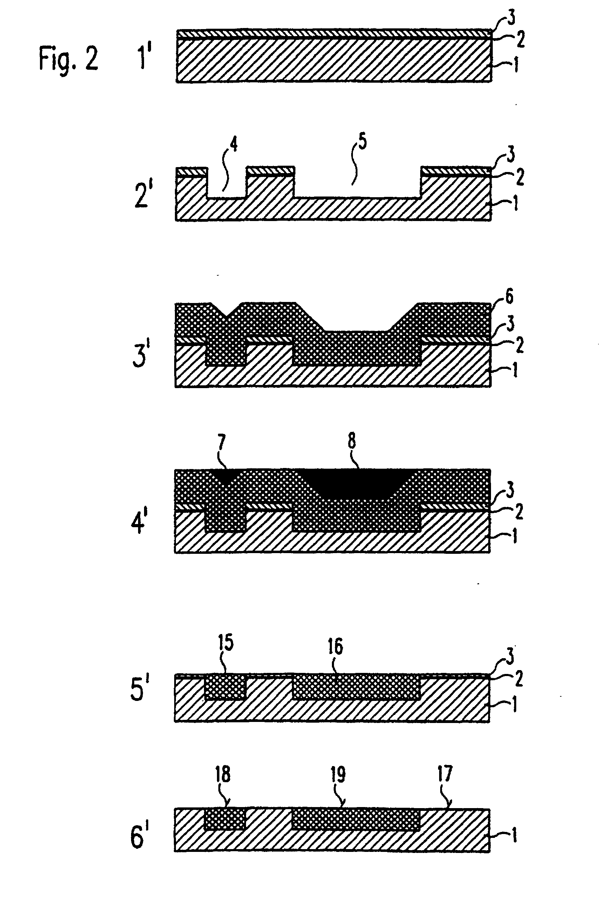

Fig. 2 zeigt ein erstes Ausführungsbeispiel des erfindungsgemäßen Verfahrens, wobei gleiche Elemente wie in Fig. 1 mit identischen Bezugsziffern versehen sind.

Zunächst wird das Siliziumsubstrat 1 mit einer dünnen thermischen Siliziumdioxidschicht 2 und einer darüberliegenden, dickeren Nitridschicht 3 versehen (Schritt 1'). Danach werden in nicht dargestellter Weise die Oxidschicht 2, die Nitridschicht 3 und gegebenenfalls auch eine weitere, darüberliegend aufgebrachte, als Maskenschicht dienende Resistschicht strukturiert und eine Plasmaätzung mit einer definierten Tiefe in das Siliziumsubstrat 1 durchgeführt (Schritt 2'). Anschließend erfolgt in Schritt 3' das Aufbringen einer TEOS-Siliziumdioxidschicht 6, wobei entsprechend der Beschreibung zu Schritt 3 in Fig. 1 zuvor gegebenenfalls eine dünne Zwischenoxidschicht aufgebracht wurde. Die abgeschiedene TEOS-Oxidschicht 6 weist eine im wesentlichen konforme Dicke auf, was bedeutet, daß auch in engen Grabenbereichen eine Schichtdicke etwa entsprechend der Schichtdicke über nichtgeätzten Bereichen des Substrats 1 erreicht wird. Dabei wird die durch die Grabenätzung erzeugte Topographie nach oben transferiert.

Nachfolgend wird eine Schicht aus undotiertem Polysilizium auf der TEOS-Oxidschicht 6 abgeschieden und durch chemisch-mechanisches Polieren des Polysiliziums (Poly-CMP) bis auf die darunterliegende TEOS-Oxidschicht 6 abgetragen. Dabei wird die sehr gute Selektivität des Poly-CMP-Prozesses zwischen Polysilizium und Siliziumdioxid ausgenutzt, die etwa 100:1 beträgt. Der Polierschritt stoppt deswegen exakt auf dem Oxid und hinterläßt eine planare Oberfläche. Sämtliches überstehende Polysilizium wird abgetragen, so daß lediglich die Polysiliziuminseln 7, 8 zurückbleiben (Schritt 4').

Die Tiefe der Gräben 4, 5 im Substrat beträgt in diesem Beispiel etwa 400 nm und die Dicke der Nitridschicht 3 liegt bei etwa 150 nm, so daß sich eine Grabentiefe (definiert als Abstand zwischen Grabenboden und Oberfläche der Nitridschicht 3) von etwa 550 nm ergibt.

Die Dicke der abgelagerten TEOS-Oxidschicht 6, gemessen über den nichtgeätzten, aktiven Substratbereichen, kann größer als die Grabentiefe (beispielsweise etwa 120% der Grabentiefe) sein, wenn ein "Overfill" der Gräben erwünscht ist. Aufgrund der Konformität der abgeschiedenen TEOS-Oxidschicht 6 ist jedoch grundsätzlich eine TEOS-Oxidschichtdicke entsprechend der Grabentiefe ausreichend.

Nachfolgend wird beim vorliegenden Ausführungsbeispiel ein nichtselektiver NF₃/N₂/CHF₃-Plasmaätzschritt mit nahezu gleichen Ätzraten für Oxid und Polysilizium durchgeführt. Bei dem hier betrachteten Beispiel wird der Ätzvorgang bei einer Hochfrequenzleistung von 800 Watt ohne zusätzliches Magnetfeld und bei einer Temperatur von 20°C durchgeführt. Der Rezipientendruck liegt bei etwa 6 Pa und es wird ein Ätzgas mit einer Zusammensetzung (Angaben in Volumen-%) von 89,5 % N₂; 2,6% CHF₃ und 7,9% NF₃ verwendet, wobei eine Selektivität zwischen Oxid und Polysilizium von 1,04:1 erreicht wird.

Die Erfindung ist nicht auf einen Plasmaätzschritt beschränkt, sondern es kann ein beliebiges Ätzverfahren angewendet werden, solange es eine ausreichend geringe Selektivität aufweist, um bei der Schichtabtragung die Aufrechterhaltung einer planaren Oberfläche zu gewährleisten. Auch sind andere Bestandteile und Zusammensetzungen des zu verwendenden Ätzgases möglich.

Der nichtselektive Ätzschritt kann exakt solange durchgeführt werden, bis sämtliches Oxidmaterial über der Nitridschicht 3 entfernt ist und eine gemeinsame planare Oxid/Nitridoberfläche 15, 16; 3 über dem Substrat 1 - wie in Fig. 2 bei Schritt 5' gezeigt - vorliegt. Andererseits ist es in nicht dargestellter Weise auch möglich, den nichtselektiven Ätzschritt bereits vor Erreichen der Nitridschicht 3 abzubrechen, sofern ein vollständiges Entfernen der Polysiliziuminseln 7, 8 bereits oberhalb der Nitridschicht 3 erfolgt ist. In diesem Fall läßt sich eine Restoxidschicht mit planarer Oberfläche und definierter Dicke über den aktiven Bereichen des Siliziumsubstrats 1 einstellen.

Eine weitere Variante besteht darin, im Anschluß an den nichtselektiven Plasmaätzschritt einen selektiven Ätzschritt zum Entfernen von Oxid anzuwenden. Dieser selektive Ätzschritt ermöglicht einerseits die Entfernung der angesprochenen, gegebenenfalls vorhandenen Restoxidschicht über dem Siliziumsubstrat 1 und andererseits eine weitergehende, selektive Ätzung des Grabenoxids 15, 16 zur Einstellung eines definierten Abstands zwischen der Oberfläche 17 des Substrats 1 in nichtgeätzten Bereichen und den Oberflächen 18, 19 des Grabenoxids 15, 16. Aufgrund der guten Selektivität, der geringen Schädigung der geätzten Oberfläche und der hohen Gleichmäßigkeit ist hierfür insbesondere ein Naßätzschritt geeignet.

Nach einer anschließenden Entfernung der Nitridschicht 3, die in Abhängigkeit von zuvor beschriebenen Varianten auch bereits vor dem selektiven Ätzschritt erfolgen kann, ergibt sich das in Fig. 2 bei Schritt 6' gezeigte Grabenprofil des Substrats 1 mit insgesamt planarer Substratoberfläche.

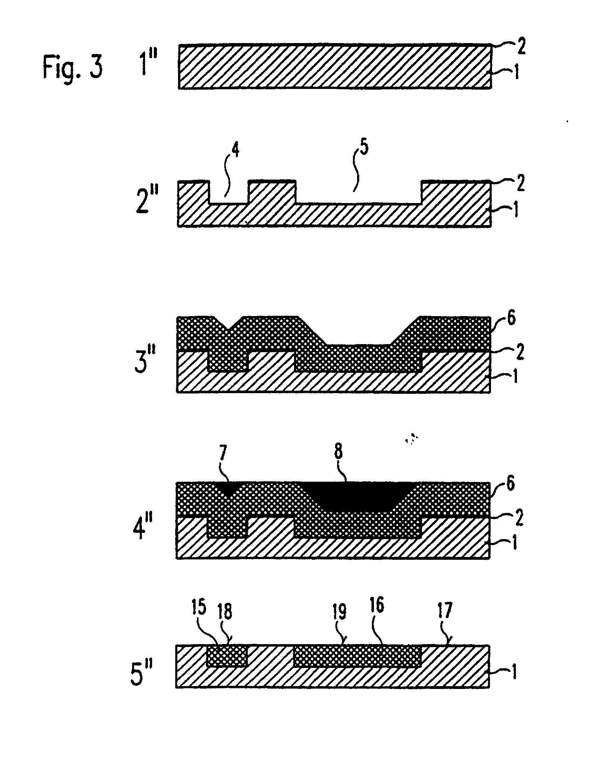

Fig. 3 zeigt Prozeßschritte 1'' bis 5'' eines zweiten Ausführungsbeispiels des erfindungsgemäßen Verfahrens. Wie auch schon beim ersten Ausführungsbeispiel gemäß Fig. 2 wurden Reinigungs- und Vorbereitungsschritte sowie ggfs. weitere zusätzliche Maßnahmen nicht in die Darstellung einbezogen. Das zweite Ausführungsbeispiel unterscheidet sich im wesentlichen lediglich dadurch von dem ersten Ausführungsbeispiel, daß auf die Nitridschicht 3 verzichtet wird. Dies ist möglich, da bei dem erfindungsgemäß vorgesehenen nichtselektiven Pläsmaätzschritt (Schritt 5' bzw. 5'') nicht die beim bekannten Verfahren nach Fig.1 erforderliche Stoppfunktion der Nitridschicht in bezug auf den Oxid-Polierprozeß (Schritt 6) benötigt wird.

Das zweite Ausführungsbeispiel bietet die Vorteile, daß durch den Verzicht auf die Nitridschicht 3 die hierfür erforderlichen Schichtabscheidungs- und Schichtentfernungsschritte entfallen und das Aspektverhältnis (Verhältnis von Grabentiefe zu Grabenbreite) beim Grabenätzen verkleinert und die erforderliche TEOS-Oxidschichtdicke verringert werden kann. Die letztgenannnten Vorteile lassen sich auch bei dem ersten Ausführungsbeispiel mit Nitridschicht 3 erreichen, wenn die Dicke der Nitridschicht 3 in geeigneter Weise verkleinert wird.

In Tab. 1 sind typische Werte für die beim Polierverfahren (Poly-CMP) und beim nichtselektiven Plasmaätzverfahren erreichten Selektivitäten (S) und Oberflächengleichmäßigkeiten (GM) angegeben.

**Tab. 1**

| | GM: Oxid-Abtrag | GM: Poly-Abtrag | GM: Nitrid Abtrag | S: Oxid:Poly | S: Oxid:Nitrid |
|---|---|---|---|---|---|
| Plasma-Ätzen | 3,40% | 1,43% | 1,36% | 1,04 | 0,99 |
| Poly-CMP | 5,00% | 2,50% | 5,00% | 0,01 | 4,00 |

Die Werte machen deutlich, daß das nichtselektive Plasmaätzverfahren im Vergleich zum Poly-CMP-Verfahren eine bessere Gleichmäßigkeit der bearbeiteten Oberflächen liefert und somit die beim Poly-CMP-Verfahren erreichte Gleichmäßigkeit nicht verschlechtert. Die Werte für die Selektivitäten betragen beim nichtselektiven Plasmaätzverfahren etwa 1 und sind für einen gleichmäßigen Schichtabtrag unter Wahrung der Ebenheit völlig ausreichend.

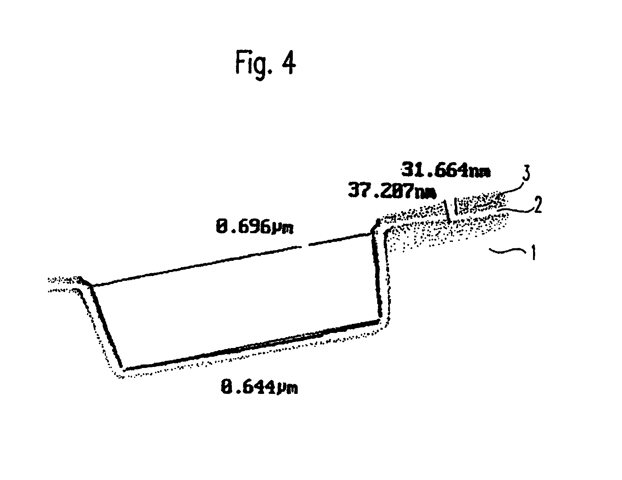

Fig. 4 zeigt eine rasterelektronenmikroskopische Querschnittaufnahme eines Grabens in einem Substrat 1 mit dünner thermischer Oxidschicht 2 und CVD-Nitridschicht 3 nach der erfindungsgemäßen nichtselektiven Oxid-Polysilizium-Plasmaätzung. Die Gesamtdicke der beiden Schichten beträgt etwa 37 nm, wobei die Dicke der Nitridschicht etwa bei bei 32 nm liegt. Das Substrat wurde nach dem erfindungsgemäßen nichtselektiven Ätzschritt der bereits beschriebenen selektiven Oxid-Naßätzung ausgesetzt, wodurch das Oberflächenniveau des Grabenoxids unter das Oberflächenniveau der das Substrat abdeckenden Nitridschicht 3 abgesenkt wurde. Demgemäß beträgt die Grabentiefe 696 nm, während der Abstand zwischen Grabenboden und Oberfläche des Grabenoxids 644 nm beträgt.

## Patentansprüche

1. Verfahren zur Ausbildung einer Grabenstruktur in einem Siliziumsubstrat, die einen ersten Bereich des Substrates elektrisch von einem zweiten Bereich des Substrates isoliert, das die folgenden Verfahrensschritte aufweist:
a) Aufwachsen einer thermischen Oxidschicht (2) auf die Substratoberfläche,
b) Aufbringen und Strukturieren einer Maskenschicht über der thermischen Oxidschicht (2),
c) Ätzen eines Grabens (4, 5) unter Verwendung der strukturierten Maskenschicht bis zu einer vorgegebene Tiefe in das Siliziumsubstrat (1),
d) Abscheidung einer im wesentlichen konformen Deckoxidschicht (6) mit einer im wesentlichen gleichmäßigen, zum vollständigen Auffüllen des Grabens (4, 5) ausreichenden Dicke,
e) Abscheidung einer Polysiliziumschicht auf der Deckoxidschicht (6), wobei die Dicke der Polysiliziumschicht mindestens der Grabentiefe entspricht,
f) chemisch-mechanisches Polieren der Polysiliziumschicht bis auf die Höhe der Oberfläche der Deckoxidschicht (6) mit einer hohen Selektivität zwischen dem Polysiliziummaterial (7, 8) der Polysiliziumschicht und dem Oxidmaterial der Deckoxidschicht (6), **gekennzeichnet durch** ein
g) im wesentlichen nichtselektives, gemeinsames Ätzen des Polysiliziummaterials (7, 8) der Polysiliziumschicht und des Oxidmaterials der Deckoxidschicht (6) unter Beibehaltung einer gemäß Schritt f) erzeugten planaren Oberfläche, wobei dieser Ätzvorgang zumindest solange durchgeführt wird, bis sämtliches Polysiliziummaterial (7, 8) der Polysiliziumschicht im Bereich des Grabens (4, 5) entfernt ist.

2. Verfahren nach Anspruch 1,
**dadurch gekennzeichnet,daß**
es sich bei dem im wesentlichen nichtselektiven Ätzschritt um einen Plasmaätzschritt, insbesondere Reaktives Ionenätzen (RIE), handelt.

3. Verfahren nach Anspruch 1 oder 2,
**dadurch gekennzeichnet,daß**
bei dem im wesentlichen nichtselektiven Ätzschritt als Ätzgase NF₃/N₂/CHF₃-Gase verwendet werden.

4. Verfahren nach einem der vorhergehenden Ansprüchen
**dadurch gekennzeichnet,daß**
die Dicke der in Schritt d) abgeschiedenen Deckoxidschicht (6) größer als die Grabentiefe ist und der Ätzvorgang des Schritts g) nach Entfernung sämtlichen Polysiliziummaterials (7, 8) der Polysiliziumschicht solange fortgesetzt wird, bis der restliche Teil der Deckoxidschicht (6) eine vorgegebene Dicke über der nichtgeätzten Substratoberfläche aufweist.

5. Verfahren nach einem der vorhergehenden Ansprüchen,
**dadurch gekennzeichnet, daß**
nach Schritt a) eine Siliziumnitridschicht (3) auf die thermische Oxidschicht (2) aufgebracht wird.

6. Verfahren nach einem der vorhergehenden Ansprüchen,
**dadurch gekennzeichnet, daß**
der im wesentlichen nichtselektive Ätzschritt g) eine Selektivität zwischen Oxid- und Polysiliziummaterial im Bereich von 0,95 bis 1,05 aufweist.

7. Verfahren nach einem der vorhergehenden Ansprüchen,
**dadurch gekennzeichnet,daß**
nach Schritt g) ein selektiver Naßätzschritt zur Entfernung von Oxidmaterial durchgeführt wird.

8. Verfahren nach Anspruch 7,
**dadurch gekennzeichnet,daß**
der selektive Naßätzschritt so gesteuert wird, daß zwischen der Oberfläche (18, 19) des Oxidmaterials im Graben (4, 5) und der Oberfläche (17) des Siliziumsubstrats (1) ein vorgegebener Abstand einstellbar ist.

9. Verfahren nach einem der vorhergehenden Ansprüchen,
**dadurch gekennzeichnet,daß**
zwischen den Schritten c) und d) eine dünne Oxidunterlage konform auf das Substrat (1) aufgewachsen wird.

10. Verfahren nach einem der vorhergehenden Ansprüchen,
**dadurch gekennzeichnet, daß**
die Deckoxidschicht (6) mittels einer TEOS-Gasphasenabscheidung abgeschieden wird.

## Claims

1. Method for forming a trench structure in a silicon substrate, which trench structure electrically insulates a first region of the substrate from a second region of the substrate, which method has the following method steps:
a) growth of a thermal oxide layer (2) on the substrate surface,
b) application and patterning of a mask layer over the thermal oxide layer (2),
c) etching of a trench (4, 5) using the patterned mask layer down to a predetermined depth into the silicon substrate (1),
d) deposition of an essentially conformal covering oxide layer (6) with an essentially uniform thickness that is sufficient for completely filling the trench (4, 5),
e) deposition of a polysilicon layer on the covering oxide layer (6), the thickness of the polysilicon layer corresponding at least to the trench depth,
f) chemical mechanical polishing of the polysilicon layer as far as the level of the surface of the covering oxide layer (6) with high selectivity between the polysilicon material (7, 8) of the polysilicon layer and the oxide material of the covering oxide layer (6), **characterized by** an
g) essentially nonselective, joint etching of the polysilicon material (7, 8) of the polysilicon layer and of the oxide material of the covering oxide layer (6) while maintaining a planar surface produced in accordance with step f), this etching operation being carried out at least until all the polysilicon material (7, 8) of the polysilicon layer has been removed in the region of the trench (4, 5).

2. Method according to Claim 1,
**characterized in that**
the essentially nonselective etching step is a plasma etching step, in particular reactive ion etching (RIE).

3. Method according to Claim 1 or 2,
**characterized in that**
NF₃/N₂/CHF₃ gases are used as etching gases in the essentially nonselective etching step.

4. Method according to one of the preceding claims,
**characterized in that**
the thickness of the covering oxide layer (6) deposited in step d) is larger than the trench depth and the etching operation of step g) is continued after the removal of all the polysilicon material (7, 8) of the polysilicon layer until the remaining part of the covering oxide layer (6) has a predetermined thickness above the unetched substrate surface.

5. Method according to one of the preceding claims,
**characterized in that**
after step a), a silicon nitride layer (3) is applied to the thermal oxide layer (2).

6. Method according to one of the preceding claims,
**characterized in that**
the essentially nonselective etching step g) has a selectivity between oxide and polysilicon material in the range of from 0.95 to 1.05.

7. Method according to one of the preceding claims,
**characterized in that**
after step g), a selective wet etching step is carried out in order to remove oxide material.

8. Method according to Claim 7,
**characterized in that**
the selective wet etching step is controlled in such a way that a predetermined distance can be set between the surface (18, 19) of the oxide material in the trench (4, 5) and the surface (17) of the silicon substrate (1).

9. Method according to one of the preceding claims,
**characterized in that**
between steps c) and d), a thin oxide support is grown conformally on the substrate (1).

10. Method according to one of the preceding claims,
**characterized in that**
the covering oxide layer (6) is deposited by means of TEOS vapour phase deposition.

## Revendications

1. Procédé de formation dans un substrat en silicium d'une structure en sillons qui isole électriquement une première partie du substrat d'une deuxième partie du substrat, comprenant les stades suivants de procédé:
a) on fait croître une couche (2) d'oxyde thermique à la surface du substrat,
b) on dépose et on structure une couche de masquage sur la couche (2) d'oxyde thermique,
c) on ménage par attaque chimique un sillon (4, 5) en utilisant la couche de masquage structurée jusqu'à une profondeur prescrite dans le substrat (1) en silicium,
d) on dépose une couche (6) d'oxyde supérieure sensiblement conforme ayant une épaisseur sensiblement uniforme suffisante pour combler entièrement le sillon (4, 5),
e) on dépose une couche de polysilicium sur la couche (6) d'oxyde supérieure, l'épaisseur de la couche de polysilicium correspondant au moins à la profondeur du sillon,
f) on polit chimiomécaniquement la couche de polysilicium jusqu'au niveau de la surface de la couche (6) d'oxyde supérieure avec une grande sélectivité entre le polysilicium (7, 8) de la couche de polysilicium et l'oxyde de la couche (6) d'oxyde supérieur, **caractérisé en ce que**
g) on effectue une attaque commune essentiellement non sélective du polysilicium (7, 8) de la couche de polysilicium et de l'oxyde de la couche (6) d'oxyde supérieure en conservant une surface plane produite suivant le stade f), cette opération d'attaque s'effectuant au moins jusqu'à ce que tout le polysilicium (7, 8) de la couche de polysilicium a été éliminé dans la partie du sillon (4, 5).

2. Procédé suivant la revendication 1, **caractérisé en ce que** le stade d'attaque sensiblement non sélectif est un stade d'attaque au plasma, notamment un stade d'attaque ionique réactive (RIE).

3. Procédé suivant la revendication 1 ou 2, **caractérisé en ce que** dans le stade d'attaque sensiblement non sélectif on utilise, comme gaz d'attaque, les gaz NF₃/N₂/CHF₃.

4. Procédé suivant une ou plusieurs des revendications précédentes, **caractérisé en ce que** l'épaisseur de la couche (6) d'oxyde supérieure déposée au stade d) est plus grande que la profondeur du sillon et on poursuit l'opération d'attaque du stade g) après élimination de tout le polysilicium (7, 8) de la couche de polysilicium jusqu'à ce que la partie restante de la couche (6) d'oxyde supérieure ait une épaisseur prescrite sur la surface du substrat qui n'a pas été attaquée.

5. Procédé suivant l'une des revendications précédentes, **caractérisé en ce qu'**après le stade a), on dépose une couche (3) en nitrure de silicium sur la couche (2) d'oxyde thermique.

6. Procédé suivant l'une des revendications précédentes, **caractérisé en ce que** le stade g) d'attaque sensiblement non sélective a une sélectivité entre l'oxyde et le polysilicium de l'ordre de 0,95 à 1,05.

7. Procédé suivant l'une des revendications précédentes, **caractérisé en ce qu'**après le stade g), on effectue un stade d'attaque sélective en voie humide pour éliminer l'oxyde.

8. Procédé suivant la revendication 7, **caractérisé en ce qu'**on règle le stade d'attaque sélective en voie humide de manière à obtenir une distance prescrite entre la surface (18, 19) de l'oxyde dans le sillon (4, 5) et la surface (17) du substrat (1) en silicium.

9. Procédé suivant l'une des revendications précédentes, **caractérisé en ce qu'**entre les stades c) et d), on fait croître de manière conforme sur le substrat (1) une mince sous-couche d'oxyde.

10. Procédé suivant l'une des revendications précédentes,
**caractérisé en ce qu'**on dépose la couche (6) d'oxyde supérieure au moyen d'un dépôt en phase gazeuse de TEOS.
